# EUROPÄISCHE PATENTSCHRIFT

(11) **EP 1 979 106 B1**
(45) Veröffentlichungstag und Bekanntmachung des Hinweises auf die Patenterteilung: **18.08.2010**
(21) Anmeldenummer: 07701292.0
(22) Anmeldetag: 01.02.2007
(51) Int. Cl.: B21C 43/04, B08B 7/04, C23G 3/02, C23G 5/00, H05H 1/46, H01J 37/32

(54) **VERFAHREN UND VORRICHTUNG ZUR KONTINUIERLICHEN PLASMABEHANDLUNG VON MATERIALEN, INSBESONDERE ZUR ENTZUNDERUNG EINES METALLSTRANGS**
METHOD AND DEVICE FOR THE CONTINUOUS PLASMA TREATMENT OF MATERIALS, IN PARTICULAR FOR THE DESCALING OF A METAL STRAND
PROCÉDÉ ET DISPOSITIF POUR LE TRAITEMENT PAR PLASMA EN CONTINU DE MATÉRIAUX, EN PARTICULIER POUR LE DÉCALAMINAGE D'UNE BANDE MÉTALLIQUE

(30) Priorität: 02.02.2006 AT 1592006
(43) Veröffentlichungstag der Anmeldung: 15.10.2008
(73) Patentinhaber: Eiselt, Primoz, 8010 Graz (AT); Mozetic, Miran, 1000 Ljubljana (SI); Cvelbar, Uros, 5280 Idrija (SI)
(72) Erfinder: Eiselt, Primoz, 8010 Graz (AT); Mozetic, Miran, 1000 Ljubljana (SI); Cvelbar, Uros, 5280 Idrija (SI)
(74) Vertreter: Margotti, Herwig Franz
(86) Internationale Anmeldenummer: PCT/AT2007/000046
(87) Internationale Veröffentlichungsnummer: WO 2007/087661

(56) Entgegenhaltungen:
- EP-A1- 0 313 154
- WO-A-00/50667
- WO-A-2007/030850
- AT-B- 414 215
- DE-A1- 10 252 178
- DE-A1-102005 012 296
- FR-A1- 2 774 400
- JP-A- 7 132 316
- HAHN D ET AL: "MODERNE VERFAHREN ZUR ENTZUNDERUNG VON STAHLDRAEHTEN" DRAHT, MEISENBACH, BAMBERG, DE, Bd. 47, Nr. 3, 1. März 1996 (1996-03-01), Seite 194,196,198,20, XP000580445 ISSN: 0012-5911

## Beschreibung

Die vorliegende Erfindung betrifft ein Verfahren und eine Vorrichtung zur Behandlung von Materialien, insbesondere Endlosmaterialien, wie Drähte, Stäbe, Rohre, etc., gemäß dem Oberbegriff der Ansprüche 1 bzw. 9.

In vielen Produktionsprozessen werden Materialien wie Drähte, Stäbe, Rohre, etc. verwendet. Diese werden entweder als Halb- oder Endfabrikate angeliefert und im Produktionsprozess weiterverarbeitet oder direkt im Verlauf eines Produktionsprozesses hergestellt und weiterverarbeitet. Dabei stellt sich fast immer das Problem, dass diese Materialien mit einer Schicht von Verunreinigungen bedeckt sind und daher nicht unmittelbar verarbeitet werden können. Es ist zumindest eine native Schicht von Oxid auf der Oberfläche vorhanden. Häufiger sind die Materialien auch mit verschiedenen organischen und anorganischen Verunreinigungen verschmutzt. Organische Verunreinigungen sind oft Rückstände von Öl oder Fett, das während der Bearbeitung aufgebracht wurde. Anorganische Verunreinigungen beinhalten Oxide wie auch Chloride und Sulfide. Die Dicke anorganischer Verunreinigungen auf Oberflächen hängt von der Umgebung, in der die Bauelemente gelagert wurden, wie auch von der Temperatur ab. Je höher die Temperatur ist, desto dicker ist die Schicht von anorganischen Verunreinigungen. Die Schicht von Verunreinigungen auf Bauelementen sollte vor der Weiterverarbeitung entfernt werden, um eine gute Verarbeitungsqualität zu gewährleisten.

Beispielsweise muss in der Vorbereitung zum Ziehen von Stahldrähten das in Form von Stahlstangen vorliegende Ausgangsmaterial vorbehandelt werden, denn die Stahlstangen weisen zumeist eine herstellungsbedingte Zunderschicht an ihrer Oberfläche auf. Insbesondere ist Verzundern ein Nebeneffekt bei der Stahlstangenherstellung nach dem Gießen und Heißwalzen der Stange. Unter "Verzundern" bezeichnet man die Oxidation der Oberfläche der Stahlstange, die in verschiedene chemische Strukturen unterteilt werden kann: FeO und FexOy (unterteilt in eine Oberflächenschicht und tiefer eindringende Schichten). Solche Oxidschichten haben eine wesentlich größere (keramikähnliche) Härte als Stahl und verursachen dadurch eine starke Abnutzung des Ziehsteins, wenn der verzunderte Stahlstab durch den Ziehstein gezogen wird.

Herkömmliche Verfahren der Reinigung von Oberflächen metallischer Bauteile beinhalten mechanische und chemische Behandlungen. Eine mechanische Reinigung wird oft durch Bürsten oder Sandstrahlen durchgeführt, während eine chemische Reinigung durch Eintauchen der Materialien in eine Lösung von Chemikalien gefolgt von einem Abspülen mit destilliertem Wasser und anschließendem Trocknen durchgeführt wird. Keines dieser Verfahren gewährleistet jedoch eine perfekte Reinheit der Materialien, sondern es besteht noch immer eine dünne Schicht an Verunreinigungen an der Oberfläche.

Auch das Problem der Entzunderung von Materialien konnte bisher nicht zu vertretbaren Kosten in den Griff bekommen werden. Die bisher angewandten Entzunderungsverfahren lassen sich in zwei Gruppen einteilen, nämlich die chargenweise Entzunderung und die in-line Entzunderung.

Bei der chargenweisen Entzunderung wird eine Charge des zu entzundernden Materials, z.B. eine Drahtrolle, in ein großes Bad eingebracht, das mit einer Mischung aus Säuren und Laugen gefüllt ist. Das Material wird in dem Bad für einige Stunden verweilen gelassen. Dadurch wird zwar der gesamte Zunder abgeätzt, aber es besteht das Problem, dass nach der Herausnahme aus dem Bad das Material eine erneute Oxidschicht bildet. Um dies zu verhindern, muss man die Oberfläche des Materials in einem weiteren Arbeitsgang passivieren, was aber wiederum einen zusätzlichen Arbeitsgang des Aktivierens des Materials nach seiner Verarbeitung, z.B. dem Hindurchziehen durch einen Ziehstein, erfordert, damit das Material wieder durch Schmiermittel etc. benetzbar wird. Außerdem ist es durch das beschriebene chargenweise Entzunderungsverfahren nicht möglich, mit vertretbarem Aufwand rostige Teile aus dem Inneren des Materials (20 µm und mehr unter der Oberfläche) zu entfernen. Um beispielsweise bei einem Stahldraht mit einem Durchmesser von 6 mm Korrosionen aus einer Materialtiefe von 40 µm vollständig durch Abätzen oder mechanisches Abtragen zu entfernen, müsste Material mit einer Querschnittsfläche von 0,75 mm² abgetragen werden, was einem Draht mit einem Durchmesser von 0,7 mm bzw. 2,7 % des Materials entspricht. Bei einem marktüblichen Preis von 600 € pro Tonne würde dies 16,2 € Mehrkosten pro Tonne verursachen. Die Kosten des Entzunderungsverfahrens selbst betragen ca. 10 bis 100 € pro Tonne, abhängig von den Drahtdimensionen (je größer der Drahtdurchmesser, desto billiger). Aufgrund dieser hohen Kosten und des hohen Zeitaufwands wird diese Art von Entzunderung großtechnisch daher nicht angewendet.

Zur Verringerung von Kosten, Arbeits- und Logistikaufwand wurde daher ein in-line Entzunderungsverfahren entwickelt, bei dem das Material (Stahldraht) kontinuierlich durch eine Behandlungsanlage bewegt und dabei bearbeitet wird. Dieses bekannte Entzunderungsverfahren umfasst mehrere Produktionsschritte:

Zunächst erfolgt eine mechanische Entzunderung des zugeführten Stahldrahts durch Biegen und Verdrehen des Stahldrahts, wodurch FeO und FexOy von der Oberfläche des Stahldrahts abfällt. Durch diese Maßnahme kann zwar ein beträchtlicher Anteil des Zunders entfernt werden, es verbleibt jedoch eine harte, schwarze Rest-Zunderschicht, die vor dem Ziehen des Drahtes unbedingt entfernt werden muss.

Daher wird in einem zweiten Schritt der Draht durch chemische Prozesse oder mechanisches Bürsten weiter behandelt. Aber auch dieser Reinigungsschritt vermag nicht allen Zunder zu entfernen, sondern es verbleiben immer noch Zunderstellen auf der Drahtoberfläche, die in der späteren Verarbeitung zu einem erhöhten Schmiermittelbedarf führen.

Vor dem Ziehen des Stahldrahtes wird ein Primer (Seifenträger) auf die Oberfläche des Stahldrahtes aufgebracht, um eine gute Adhäsion zwischen dem Material und einem Schmiermittel zu erzielen, das vor dem Ziehvorgang auf die Materialoberfläche aufzubringen ist. Für die meisten Anwendungen muss der Draht aufgeheizt werden, um das Phosphatieren oder eine Boraxbehandlung zu beschleunigen und den Ziehvorgang zu erleichtern. Diese Behandlungen stellen eine Aktivierung der Oberfläche des Materials dar.

In einem vierten Schritt wird der Draht eingefettet, um den Draht leichter durch den Ziehstein ziehen zu können. Für das Einfetten des Drahtes werden meist Na- oder Ca-Stearate verwendet. Da, wie oben beschrieben, immer noch Rest-Zunder auf der Materialoberfläche haftet, muss eine wesentlich größere Menge an Schmiermittel aufgebracht werden als dies sonst erforderlich wäre.

Der vorliegenden Erfindung liegt die Aufgabe zugrunde, ein Materialbehandlungsverfahren und eine Materialbehandlungsvorrichtung bereitzustellen, die die Nachteile des Standes der Technik vermeiden. Insbesondere soll durch die Erfindung ein Verfahren und eine Vorrichtung zur Reinigung, speziell zur Entzunderung, von Materialien bereitgestellt werden, dass nicht nur an der Oberfläche des Materials wirkt, sondern auch eine Tiefenwirkung besitzt, und das darüber hinaus in großtechnischem Maßstab zu sehr günstigen Kosten durchführbar ist. Trotz der Tiefenwirkung bei der Materialbehandlung soll die Erfindung nicht mit der Abtragung von beträchtlichen Materialmengen verknüpft sein.

Die vorliegende Erfindung löst die gestellte Aufgabe durch ein Verfahren zur Behandlung von Materialien, insbesondere Endlosmaterialien, wie Drähte, Stäbe, Rohre, etc., mit den kennzeichnenden Merkmalen des Anspruchs 1, sowie durch eine Materialbehandlungsvorrichtung mit den kennzeichnenden Merkmalen des Anspruchs 11. Vorteilhafte Ausgestaltungen der Erfindung sind in den Unteransprüchen dargelegt.

Die vorliegende Erfindung umfasst das Hindurchbewegen von Materialien, insbesondere von Endlosmaterialien durch eine Behandlungsvorrichtung, das Erhitzen des Materials während seiner Hindurchbewegung durch die Behandlungsvorrichtung und anschließendes Unterziehen einer Plasmabehandlung, wobei die Plasmabehandlung in einer Plasmabehandlungsatmosphäre aus Wasserstoff oder Wasserstoff gemischt mit Edelgas erfolgt und eine Konzentration von Wasserstoffradikalen in der Plasmabehandlungsatmosphäre auf zumindest 10²⁰ m⁻³ eingestellt wird.

Es hat sich als zweckmäßig erwiesen, dass gemäß der Erfindung in der Aufheizkammer eine Gasatmosphäre aus Wasserstoff oder Wasserstoff gemischt mit Edelgas herrscht, da eine solche Gasatmosphäre auch für die Entladungskammer bevorzugt ist und somit eine gemeinsame Gasatmosphären-Erzeugungseinrichtung vorgesehen werden kann. Außerdem ist durch eine Wasserstoffatmosphäre in der Aufheizkammer sichergestellt, dass kein Sauerstoff in die Entladungskammer gelangen kann, der dort schädlich wäre.

Bei der vorgesehenen Konzentration von Wasserstoffradikalen in der Plasmabehandlungsatmosphäre auf zumindest 10²⁰ m⁻³ wird die Entfernung von Rost aus dem Inneren von Drähten, Stäben und dergl. ohne substantielle Materialabtragung ermöglicht. Dieser Effekt wird weiter verbessert, wenn ein Fluss der Wasserstoffradikalen zur Oberfläche des zu behandelnden Materials in der Entladungskammer auf zumindest 10²³ m⁻² s⁻¹ eingestellt wird. Es ist vorgesehen, dass die Radikale neutrale oder positiv geladene Wasserstoffatome sind. Es ist weiters bevorzugt, dass der Druck der Plasmabehandlungsatmosphäre in der Entladungskammer zwischen 1 und 100 mbar einstellbar ist, wodurch die Einstellung der Konzentration von Wasserstoffradikalen in der Plasmabehandlungsatmosphäre auf zumindest 10²⁰ m⁻³ unterstützt wird.

Das Dokument JP 07 132316 A beschreibt eine Behandlungsstrecke für Edelstahl-Bandmaterial, die das Glühen, Plasma-Reinigen und anschließende chemische Reinigen des Bandmaterials (bzw. Endlosmaterials) umfasst. Dabei sind alle Schritte beschrieben, mit denen eine Konditionierung der Edelstahloberflächen und mechanischer Eigenschaften des Materials bewirkt werden soll, um eine weitere Verarbeitung bzw. den Verkauf zu ermöglichen. Bei dieser bekannten Anlage wird das Material nicht aufgeheizt, um es schneller reinigen zu können, sondern um mechanische Eigenschaften des Materials zu erzielen. Der zweite Schritt in der Behandlung des Edelstahlmaterials gemäß diesem Dokument ist die Plasmareinigung, die durch thermisches Plasma durchgeführt wird. Thermische Plasmen sind Hochdruckentladungen, die nur unter Atmosphärendruck (bzw. Hochdruck) erzeugt werden, wie z.B. eine Bogenentladung.

Das Dokument DE 10320472 AI beschreibt ein Plasmabehandlungsverfahren zur Reinigung von elektronischen Bauteilen, die aus Kupfer oder Nickel hergestellt sind. Das Verfahren umfasst das Evakuieren einer Behandlungskammer, Einleiten von Sauerstoff in die Behandlungskammer, Anregen eines Plasmas in der Kammer, Einwirken von Sauerstoffradikalen auf die Bauelemente. Diese Schritte werden anschließend mit Wasserstoff bzw. Wasserstoffradikalen wiederholt. Dieses Dokument enthält keinerlei Angaben über die dazu notwendige Konzentration von Wasserstoffradikalen in der Plasmabehandlungsatmosphäre.

Die Erfindung zeichnet sich dadurch aus, dass Materialien, insbesondere Endlosmaterialien, wie Drähte, Stäbe, Rohre, etc., insbesondere solche aus Stahl, durch eine Aufheizkammer geführt und darin erhitzt und anschließend durch einen Plasmareaktor mit zumindest einer Entladungskammer geführt und darin einer Plasmabehandlung unterzogen werden. Das Material wird somit in-line, d.h. in kontinuierlicher Bewegung behandelt. Beim Einsatz der Erfindung zur Entzunderung des Materials wird durch das Aufheizen des Materials ein Großteil des darauf befindlichen Zunders zum Abblättern gebracht, der restliche Teil des Zunders wird anschließend in der Entladungskammer entfernt.

Die vorliegende Erfindung eignet sich hervorragend zum Entzundern von Materialien, wobei die Entzunderung äußerst billig und dennoch vollkommen zufriedenstellend durchgeführt werden kann. Aufgrund der verbesserten Entzunderung des Ausgangsmaterials können bei Drahtziehanlagen Standzeiten von bis zu 95% erzielt werden, verglichen mit heutzutage maximal erreichbaren 70%. Da durch das erfindungsgemäße Verfahren auch die Anzahl an Arbeitsschritten gegenüber dem Stand der Technik reduziert wird, kann eine große Reduzierung der Produktionskosten erzielt werden. Außerdem unterliegen Ziehsteine etc. einer geringeren Abnützung. Die vorliegende Erfindung löst auch die Aufgabe, Rost aus dem Inneren der Stahlstangen zu entfernen, ohne dass dabei ein wesentlicher Materialverlust auftritt.

Zur Aufheizung des Materials ist in Ausgestaltungen der Erfindung vorgesehen, dass die Aufheizkammer eine Widerstandsheizung, oder einen Flammenbrenner, oder eine induktive Heizung, kapazitiv gekoppelte HF Entladung, oder einen Laser, oder eine Lichtheizeinrichtung oder eine Plasmaerzeugungseinrichtung umfasst. Das Material sollte auf zumindest 100 °C aufgeheizt werden, damit bereits in der Aufheizkammer ein beträchtlicher Teil des Zunders abfällt und damit die Reduktion der Oberfläche des Materials in der nachfolgenden Entladungskammer schneller startenden kann und folglich ein geringerer Gasverbrauch in der Entladungskammer erreicht werden kann.

In bevorzugten Ausgestaltungen der Erfindung werden die Entladungen in der Entladungskammer des Plasmareaktors durch eine induktive RF-Entladungserzeugungseinrichtung oder eine Mikrowellenentladungserzeugungseinrichtung erzeugt.

Um zu verhindern, dass eine Rekombination von H₂ Radikalen auftritt, ist in einer Ausgestaltung der Erfindung vorgesehen, dass die zumindest eine Gasentladungskammer von Wänden begrenzt wird, die aus einem Material bestehen oder an den der Gasentladungskammer zugewandten Oberflächen mit einem Material beschichtet sind, das einen niedrigen Rekombinationskoeffizienten für die Zusammensetzung der Gasatome in Moleküle bzw. Radikale besitzt, wobei das Material vorzugsweise ein Glas, wie z.B. Quarzglas, oder ein fluoriertes Polymer, wie z.B. PTFE, ist.

Eine weitere Reduzierung der Rekombination von Radikalen kann erreicht werden, wenn die die Gasentladungskammer begrenzenden Wände gekühlt werden, wobei die Kühlung vorzugsweise auf unter 60 °C Wandtemperatur erfolgt.

Um zu verhindern, dass in der Aufheizkammer vom Material abgetragene Schmutzteilchen oder mit dem Material in die Aufheizkammer gelangte O₂-Atome in die Gasentladungskammer gelangen, ist in einer Fortbildung der Erfindung eine Trennstufe zwischen der Aufheizkammer und der Gasentladungskammer des Plasmareaktors vorgesehen, die die Gasatmosphären in der Aufheizkammer und der Gasentladungskammer voneinander entkoppelt. Als zusätzliche Maßnahme zur Verhinderung der Kontamination der Gasentladungskammer durch Teilchen aus der Aufheizkammer kann der Druck in der Aufheizkammer niedriger eingestellt werden als in der Gasentladungskammer.

Die Erfindung wird nun anhand eines Ausführungsbeispiels unter Bezugnahme auf die Zeichnungen näher erläutert.
Fig. 1 zeigt ein schematisches Bild einer erfindungsgemäßen Materialbehandlungsvorrichtung.
Fig. 2 zeigt einen schematischen Längsschnitt des Plasmareaktors der erfindungsgemäßen Materialbehandlungsvorrichtung.

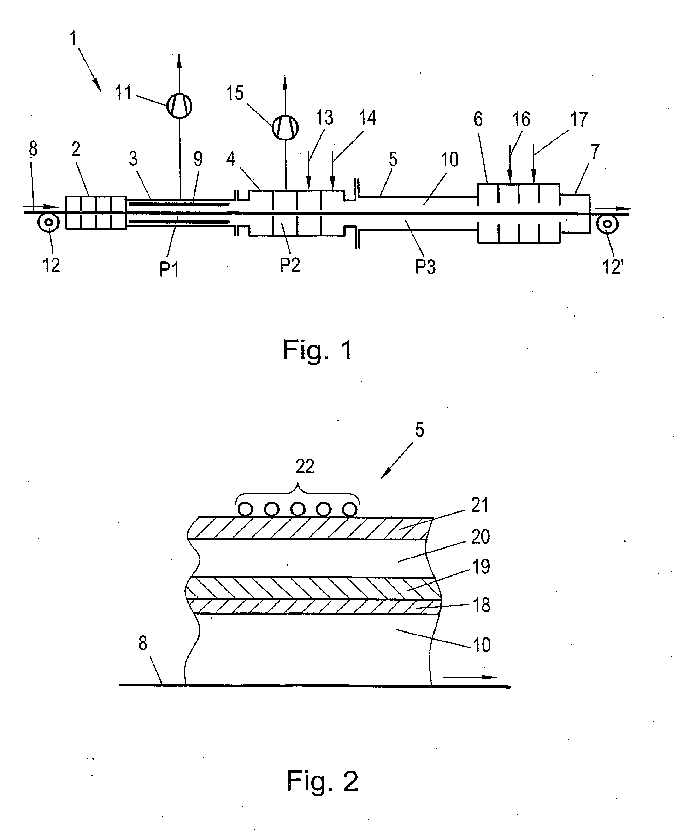

In Fig. 1 ist schematisch eine Ausführungsform einer erfindungsgemäßen Vorrichtung 1 zur Behandlung von Materialien, insbesondere Endlosmaterialien 8, wie Drähte, Stäbe, Rohre, etc., dargestellt. Das Endlosmaterial wird durch eine Schleuse 2 in eine Aufheizkammer 3 gefördert, wo es während seiner Hindurchbewegung durch die Aufheizkammer 4 von einer Heizeinrichtung 9 auf mindestens 100 °C erhitzt wird, um durch die Erhitzung auf der Oberfläche des Materials 8 befindliche Verschmutzungen, wie Zunder, großteils zum Abblättern zu bringen. In der Aufheizkammer 3 herrscht ein Druck P 1 von 0,1 bis 10 mbar, der durch eine Vakuumpumpe 11 erzeugt wird. Die Aufheizkammer 8 weist in diesem Ausführungsbeispiel eine koaxiale Geometrie auf, wobei die Heizeinrichtung 9 als Plasmaheizung ausgebildet ist, die eine äußere, als Anode arbeitende Elektrode aufweist, die als Ummantelung des Endlosmaterials in der Aufheizkammer 8 angeordnet ist. Das Endlosmaterial 8 bildet eine innere Elektrode, indem es über elektrisch leitende Rollen 12, 12' auf Massepotential gelegt wird und somit als Kathode fungiert. Zwischen den Elektroden wird durch Anlegen einer Gleichspannung eine DC Gasentladung erzeugt und damit ein Plasma generiert, das Ionendichten höher als 10⁻¹⁷ m⁻³ aufweist, womit bei einer Entladungsspannung von einigen kV ein ausgiebiges Ionenbombardement erzielt wird, das starke Oberflächenerhitzung an dem Endlosmaterial 8 hervorruft. Damit können Temperaturgradienten höher als 100 K/mm über den Querschnitt des Endlosmaterials erzielt werden. Alternative Ausführungsformen der Heizeinrichtung umfassen eine Widerstandsheizung, einen Flammenbrenner, eine induktive Heizung, einen Laser, kapazitiv gekoppelte HF Entladung, oder eine Lichtheizeinrichtung. Die Atmosphäre in der Aufheizkammer 3 ist zweckmäßig als eine Gasatmosphäre aus Wasserstoff oder Wasserstoff gemischt mit Edelgas eingestellt, wobei diese Gasatmosphäre durch Einströmen von Gas durch die Trennstufe 4 hindurch erzeugt oder die Gaszuführung über eine separate, in der Zeichnung nicht dargestellte Wasserstoff- bzw. Edelgaszufuhreinrichtung erfolgt.

An die Aufheizkammer 3 schließt sich eine Trennstufe 4 an, die dazu dient, die Aufheizkammer 3 von einem an der anderen Seite der Trennstufe 4 angeschlossenen Plasmareaktor 5 zu entkoppeln. Die Trennstufe 4 ist eine Schleuse, die über eine Gaszuleitung 13 für ein Inertgas und gegebenenfalls über eine weitere Gaszuleitung 14 für ein Edelgas verfügt. Der Druck P2 in der Trennstufe 4 wird durch eine Vakuumpumpe 15 so eingestellt, dass der höher ist als der Druck P1 in der Aufheizkammer 3, damit Gas gegebenenfalls von der Trennstufe 4 in die Aufheizkammer 3 strömen kann, aber nicht umgekehrt.

Das in der Aufheizkammer 3 erhitzte und vorgereinigte Material 8 gelangt nach seinem Durchgang durch die Trennstufe 4 in eine Entladungskammer 10 des Plasmareaktors 5, wo es einer Plasmabehandlung unterzogen wird, um die restliche, an der Oberfläche sowie im Inneren des Endlosmaterials 8 vorhandene Verschmutzung zu entfernen. Eine Ausführungsform des Plasmareaktors und seiner Wirkungsweise wird nachfolgend anhand der Fig. 2 näher erläutert. Nach der Plasmabehandlung verlässt das Endlosmaterial 8 durch ein kombiniertes Gasversorgungs-/Schleusensystem 6 die Entladungskammer 10 des Plasmareaktors und gelangt in eine Kühlstufe 7, wo es auf Temperaturen unter 100 °C abgekühlt wird und anschließend in die Umgebungsatmosphäre (Luft) geleitet und dort gegebenenfalls weiter verarbeitet wird. Das Gasversorgungs-/Schleusensystem 6 weist eine Gaszuführung 16 für Wasserstoff und eine weitere Gaszuführung 17 für ein Edelgas, wie z.B. Argon, auf. Durch die getrennten Gaszuführungen kann die Zusammensetzung der Gasatmosphäre in der Entladungskammer 10 sowie der darin herrschende Druck P3 reguliert werden. Die Gasatmosphäre weist vorzugsweise eine Zusammensetzung von 90 - 99 % Wasserstoff und 10 - 1 % Argon auf. Der Druck P3 sollte über dem Druck P2 der Trennstufe liegen, damit kein Gas- und Teilchenrückfluss aus der Trennstufe und der vorgelagerten Aufheizkammer auftritt. Vorzugsweise ist der Druck P3 auf 1 - 100 mbar eingestellt.

Fig. 2 zeigt einen schematischen Längsschnitt durch die Entladungskammer 10 des Plasmareaktors 5. Die Entladungskammer 10 ist als zylindrisches Gefäß aufgebaut, in dessen Längsachse oder parallel dazu ein oder mehrere zu reinigende Endlosmaterialien 8 hindurchgeführt werden. Alternativ zur zylindrischen Ausgestaltung kann die Entladungskammer 10 auch als längliches Vier- oder Mehreckrohr aufgebaut sein. Von innen nach außen betrachtet wird die Entladungskammer 10 von einer Innenwand 18 begrenzt, die als Beschichtung der Innenfläche einer hohlzylindrischen Mittelwand 19 ausgebildet ist. Die Mittelwand 19 wiederum wird von einer hohlzylindrischen Außenwand 21 umgeben, wobei der Innendurchmesser der Außenwand 21 so gewählt ist, dass ein Hohlraum 20 zwischen der Außenfläche der Mittelwand 19 und der Innenfläche der Außenwand 21 gegeben ist, der mit einem Kühlmedium (z.B. Wasser) durchströmt wird, um für eine ausreichende Kühlung der Innenwand 18 und der Mittelwand 19 zu sorgen und dadurch das Rekombinieren von Radikalen in der Entladungskammer 10 zu unterbinden oder zumindest zu verringern. Es ist vorgesehen, die Wandtemperatur auf unter 60 °C einzustellen. Weiters ist die Innenwand 18 aus einem Material hergestellt, das einen niedrigen Rekombinationskoeffizienten für die Zusammensetzung der Gasatome in Moleküle bzw. Radikale besitzt. Diese Materialien mit niedrigen Rekombinationskoeffizienten besitzen üblicherweise eine glatte Oberfläche und können verschiedene Glasarten oder Polymere sein, wie z.B. Quarzglas oder fluorierte Polymere, wie z.B. Polytetrafluorethylen. Weitere verwendbare Materialien sind Keramik und Thermoplaste. In der Entladungskammer wird das Plasma so generiert, dass eine niedrige kinetische Energie der Gasteilchen gewährleistet ist, womit eine Oberflächenkontaminierung mittels Zerstäubung verhindert wird. Es sei erwähnt, dass die Mittelwand 19 und die Innenwand 18 als eine einzige Wand ausgebildet sein können. Um die Außenwand 21 ist eine Spule 22 gewickelt, die ca. 5 - 15 Windungen umfasst und mit RF Strom aus einem nicht dargestellten Hochfrequenzgenerator beaufschlagt wird, wobei die Frequenz des RF Stroms zumindest 2 MHz betragen soll, aber vorzugsweise zumindest 13 MHz beträgt, z.B. ca. 27 MHz. Auf diese Weise werden in der Entladungskammer 10 induktiv gekoppelte Entladungen hervorgerufen und ein chemisches Plasma (im Unterschied zum ionischen Plasma in der Aufheizkammer 3 und bei Geräten nach dem Stand der Technik) erzeugt. Das chemische Plasma birgt im Unterschied zum ionischen Plasma nicht die Gefahr von Wasserstoffversprödung und/oder der chemischen Veränderung (z.B. Martensitbildung) der Oberfläche des Endlosmaterials in sich.

Die Konzentration von Wasserstoffradikalen in der Plasmabehandlungsatmosphäre der Entladungskammer 10 wird auf zumindest 10²⁰ m⁻³ eingestellt. Weiters wird der Fluss der Wasserstoffradikalen zur Oberfläche des zu behandelnden Materials auf zumindest 10²³ m⁻² s⁻¹ eingestellt. Die Radikale sind neutrale oder positiv geladene Wasserstoffatome.

Durch die in der Entladungskammer 10 herrschende Plasmabehandlungsatmosphäre aus Wasserstoff oder einem Gemisch aus Wasserstoff und einem Edelgas wie Argon können anorganische Verunreinigungen (hauptsächlich Oxide wie Rost) von der Oberfläche des Endlosmaterials 8 sowie auch aus dem Inneren des Endlosmaterials entfernt werden. Wasserstoffradikale, die in der Entladung erzeugt werden, treten in Wechselwirkung mit den anorganischen Oberflächenverunreinigungen und reduzieren sie zu Wasser und anderen einfachen Molekülen wie HCl, H2S, HF usw., die aus der Oberfläche desorbiert und abgepumpt werden. Nach der Wasserstoffplasmabehandlung wird die Oberfläche faktisch frei von jedweden Verunreinigungen. Es hat sich als günstig erwiesen, wenn die Plasmabehandlungsatmosphäre in der Entladungskammer ein Gemisch aus Wasserstoff und Argon mit einem Verhältnis von 95:5 ist, das eine sehr hohe Konzentration von Wasserstoffradikalen im Plasma gestattet. Die Geschwindigkeit, mit der Wasserstoffradikale im gasförmigen Plasma, das Wasserstoff enthält, gebildet werden, hängt von der Leistung der Entladungsquelle ab.

Ein besonderer Aspekt der vorliegenden Erfindung ist darin zu sehen, dass aufgrund der spezifischen Bedingungen während der Behandlung kein oder nur ein geringer Beschuss der Oberfläche mit hochenergetischen Ionen erfolgt, was sich als besonders günstig erweist.

Ein wesentliches Merkmal der Erfindung ist, dass die Materialbehandlungsvorrichtung 1 eine sogenannte in-line Vorrichtung ist, das heißt, dass das Material 8 kontinuierlich durch die Vorrichtung geführt wird, z.B. indem es aus einer Spule oder von einem Bund abgewickelt wird. Die erfindungsgemäße Materialbehandlungsvorrichtung 1 kann auch als eine Multiline-Vorrichtung ausgeführt sein, der parallel mehrere zu behandelnde Endlosmaterialien 8 zugeführt werden.

## Patentansprüche

1. Verfahren zur Behandlung von Materialien (8), insbesondere Endlosmaterialien, wie Drähte, Stäbe, Rohre, etc., wobei das Material (8) während seiner Hindurchbewegung durch eine Behandlungsvorrichtung erhitzt und anschließend einer Plasmabehandlung unterzogen wird, **dadurch gekennzeichnet, dass** die Plasmabehandlung in einer Plasmabehandlungsatmosphäre aus Wasserstoff oder Wasserstoff gemischt mit Edelgas erfolgt und dass eine Konzentration von Wasserstoffradikalen in der Plasmabehandlungsatmosphäre auf zumindest 10²⁰ m⁻³ eingestellt wird

2. Verfahren nach Anspruch 1, **dadurch gekennzeichnet, dass** ein Fluss der Wasserstoffradikalen zur Oberfläche des zu behandelnden Materials (8) auf zumindest 10²³ m⁻² s⁻¹ eingestellt wird.

3. Verfahren nach Anspruch 1 oder 2, **dadurch gekennzeichnet, dass** die Radikale neutrale oder positiv geladene Wasserstoffatome sind.

4. Verfahren nach einem der vorhergehenden Ansprüche , **dadurch gekennzeichnet, dass** das Material (8) durch Joulesche Erwärmung, Flamme, Induktive Erwärmung, kapazitiv gekoppelte HF Entladung, Laser, Licht oder Plasma erhitzt wird.

5. Verfahren nach einem der vorhergehenden Ansprüche , **dadurch gekennzeichnet, dass** das Material (8) auf zumindest 100 °C erhitzt wird.

6. Verfahren nach einem der vorhergehenden Ansprüche, **dadurch gekennzeichnet, dass** das Material (8) in einer Atmosphäre aus Wasserstoff oder Wasserstoff gemischt mit Edelgas erhitzt wird.

7. Verfahren nach einem der vorhergehenden Ansprüche, **dadurch gekennzeichnet, dass** bei der Plasmabehandlung Entladungen mittels induktiver RF-Entladung oder Mikrowellenentladung erzeugt werden.

8. Verfahren nach einem der vorhergehenden Ansprüche, **dadurch gekennzeichnet, dass** der Druck in der Plasmabehandlungsatmosphäre zwischen 1 und 100 mbar eingestellt wird.

9. Vorrichtung (1) zur Behandlung von Materialien, insbesondere Endlosmaterialien, wie Drähte, Stäbe, Rohre, etc., umfassend eine Aufheizkammer (3) zum Erhitzen von zugeführtem Material (8) während seiner Bewegung durch die Aufheizkammer (3) und einen stromabwärts von der Aufheizkammer angeordneten Plasmareaktor (5) mit zumindest einer Entladungskammer (10), durch die hindurch das Material (8) kontinuierlich transportierbar ist und in der das Material während seiner Hindurchbewegung einer Plasmabehandlung unterziehbar ist, **dadurch gekennzeichnet, dass** der Plasmareaktor (5) eine Einrichtung (6) zur Einstellung einer Plasmabehandlungsatmosphäre aus Wasserstoff oder Wasserstoff gemischt mit Edelgas in der wenigstens einen Entladungskammer aufweist und dass eine Konzentration von Wasserstoffradikalen in der Plasmabehandlungsatmosphäre auf zumindest 10²⁰ m⁻³ einstellbar ist.

10. Vorrichtung nach Anspruch 9, **dadurch gekennzeichnet, dass** ein Fluss der Wasserstoffradikalen zur Oberfläche des zu behandelnden Materials (8) in der Entladungskammer auf zumindest 10²³ m⁻² s⁻¹ einstellbar ist.

11. Vorrichtung nach Anspruch 9 oder 10, **dadurch gekennzeichnet, dass** die Radikale neutrale oder positiv geladene Wasserstoffatome sind.

12. Vorrichtung nach einem der Ansprüche 9 bis 11, **dadurch gekennzeichnet, dass** die Aufheizkammer (3) eine Heizeinrichtung (9), wie eine Widerstandsheizung, einen Flammenbrenner, eine induktive Heizung, kapazitiv gekoppelte HF Entladung, einen Laser, eine Lichtheizeinrichtung oder eine Plasmaerzeugungseinrichtung umfasst.

13. Vorrichtung nach einem der Ansprüche 9 bis 12, **dadurch gekennzeichnet, dass** die Aufheizkammer (3) eine Einrichtung zur Zuführung von Wasserstoff und optional Edelgas umfasst.

14. Vorrichtung nach einem der Ansprüche 9 bis 13, **dadurch gekennzeichnet, dass** der Plasmareaktor (5) eine induktive RF-Entladungserzeugungseinrichtung (22) oder eine Mikrowellenentladungserzeugungseinrichtung umfasst.

15. Vorrichtung nach einem der Ansprüche 9 bis 14, **dadurch gekennzeichnet, dass** der Druck der Plasmabehandlungsatmosphäre in der Entladungskammer (10) zwischen 1 und 100 mbar einstellbar ist.

16. Vorrichtung nach einem der Ansprüche 9 bis 15, **dadurch gekennzeichnet, dass** die zumindest eine Gasentladungskammer (10) von Wänden (18) begrenzt wird, die aus einem Material bestehen oder an den der Gasentladungskammer zugewandten Oberflächen mit einem Material beschichtet sind, das einen niedrigen Rekombinationskoeffizienten für die Zusammensetzung der Gasatome in Moleküle bzw. Radikale besitzt, wobei das Material vorzugsweise ein Glas, wie z.B. Quarzglas, oder ein fluoriertes Polymer, wie z.B. PTFE, ist.

17. Vorrichtung nach Anspruch 16, **dadurch gekennzeichnet, dass** die die Gasentladungskammer (10) begrenzenden Wände (18, 19) gekühlt werden, wobei die Kühlung vorzugsweise auf eine Wandtemperatur unter 60 °C erfolgt.

18. Vorrichtung nach einem der Ansprüche 9 bis 17, **dadurch gekennzeichnet, dass** zwischen der Aufheizkammer (3) und der Gasentladungskammer (10) des Plasmareaktors (5) eine Trennstufe (4) vorgesehen ist, die die Gasatmosphären in der Aufheizkammer und der Gasentladungskammer voneinander entkoppelt.

19. Vorrichtung nach einem der Ansprüche 9 bis 18, **dadurch gekennzeichnet, dass** der Druck (P1) in der Aufheizkammer (3) niedriger eingestellt ist als der Druck (P3) in der Gasentladungskammer (10).

## Claims

1. A method for treating materials (8), in particular continuous materials such as wires, rods, tubes, etc., with the material (8) being heated by a treatment device when it is passed therethrough and subsequently being subjected to a plasma treatment, **characterized in that** the plasma treatment is performed in a plasma treatment atmosphere of hydrogen or hydrogen mixed with inert gas and that there is adjusted a concentration of hydrogen radicals in the plasma treatment atmosphere amounting to at least 10²⁰ m³.

2. A method according to claim 1, **characterized in that** a flow of hydrogen radicals to the surface of the material (8) to be treated is adjusted to at least 10²³ m⁻² s⁻¹.

3. A method according to claim 1 or 2, **characterized in that** the radicals are neutral or positively charged hydrogen atoms.

4. A method according to any of the claims above, **characterized in that** the material (8) is heated through Joule heating, flame, inductive heating, capacitively coupled high frequency discharge, laser, light, or plasma.

5. A method according to any of the claims above, **characterized in that** the material (8) is heated up to at least 100 °C.

6. A method according to any of the claims above, **characterized in that** the material (8) is heated in an atmosphere of hydrogen or hydrogen mixed with inert gas.

7. A method according to any of the claims above, **characterized in that** there is generated discharge by means of RF discharge or microwave discharge.

8. A method according to any of the claims above, **characterized in that** there is adjusted the pressure in the plasma treatment atmosphere between 1 and 100 mbar.

9. A device (1) for treating materials, in particular continuous materials such as wires, rods, tubes, etc., comprising a heating chamber (3) for heating the material (8) fed while it is moving through the heating chamber (3) as well as a plasma reactor (5) arranged downstream of the heating chamber with at least one discharge chamber (10), through which the material (8) may be continuously transported and in which the material may be subjected to a plasma treatment on its movement therethrough, **characterized in that** the plasma reactor (5) has a device (6) for adjusting a plasma treatment atmosphere of hydrogen or hydrogen mixed with inert gas in the at least one discharge chamber and that a concentration of hydrogen radicals in the plasma treatment atmosphere is adjustable to at least 10²⁰ m⁻³_{.}

10. A device according to claim 9, **characterized in that** a flow of the hydrogen radicals to the surface of the material (8) to be treated in the discharge chamber is adjustable to at least 10²³ m⁻²s⁻¹.

11. A device according to claim 9 or 10, **characterized in that** the radicals are neutral or positively charged hydrogen atoms.

12. A device according to any of the claims 9 to 11, **characterized in that** the heating chamber (3) comprises a heating device (9) such as a resistance heating, a flame burner, an inductive heating, a capacitively coupled HF discharge, a laser, a light heating device or a plasma generation device.

13. A device according to one of the claims 9 to 12, **characterized in that** the heating chamber (3) comprises a device for feeding hydrogen and optionally inert gas.

14. A device according to any of the claims 9 to 13, **characterized in that** the plasma reactor (5) comprises an inductive RF discharge generating device (22) or a mivrowave discharge generating device.

15. A device according to any of the claims 9 to 14, **characterized in that** the pressure of the plasma treatment atmosphere in the discharge chamber (10) is adjusted between 1 and 100 mbar.

16. A device according to any of the claims 9 to 15, **characterized in that** the at least one gas discharge chamber (10) is defined by walls (18) consisting of a material or being covered at the surfaces facing the gas discharge chamber by a material that has a low recombination coefficient for the composition of the gasous atoms in molecules and radicals, respectively, with the material being preferably a glass, such as quartz glass, or a fluorinated polymer such as, for example, PTFE.

17. A device according to claim 16, **characterized in that** the walls (18, 19) defining the gas discharge chamber (10) are cooled, with the cooling process reaching preferably a wall temperature of less than 60°C.

18. A device according to any of the claims 9 to 17, **characterized in that** there is provided a separation stage (4) between the heating chamber (3) and the gas discharge chamber (10) of the plasma reactor (5), which decouples the gasous atmospheres in the heating chamber and in the gas discharge chamber.

19. A device according to any of the claims 9 to 18, **characterized in that** the pressure (P1) in the heating chamber (3) is adjusted at a lower level than the pressure (P3) in the gas discharge chamber (10).

## Revendications

1. Procédé pour le traitement de matériaux (8), en particulier de matériaux sans fin, comme des fils, des barres, des tubes, etc., dans lequel le matériau (8) est réchauffé pendant son déplacements à travers un appareil de traitement et ensuite soumis à un traitement au plasma, **caractérisé en ce que** le traitement au plasma a lieu dans une atmosphère de traitement au plasma constituée d'hydrogène ou d'hydrogène mélangé à des gaz rares, et **en ce que** l'on établit une concentration de radicaux hydrogène dans l'atmosphère de traitement au plasma à au moins 10²⁰ m⁻³.

2. Procédé selon la revendication 1, **caractérisé en ce que** l'on établit un flux de radicaux hydrogène vers la surface du matériau à traiter (8) à au moins 10²³ m⁻² s⁻¹.

3. Procédé selon la revendication 1 ou 2, **caractérisé en ce que** les radicaux sont des atomes d'hydrogène neutres ou positivement chargés.

4. Procédé selon l'une des revendications précédentes, **caractérisé en ce que** le matériau (8) est réchauffé par effet joule, à la flamme, par voie inductive, par décharge haute fréquence à couplage capacitif, au moyen d'un laser, de lumière ou d'un plasma.

5. Procédé selon l'une des revendications précédentes, **caractérisé en ce que** le matériau (8) est chauffé à au moins 100°C.

6. Procédé selon l'une des revendications précédentes, **caractérisé en ce que** le matériau (8) est chauffé dans une atmosphère d'hydrogène ou d'hydrogène mélangé à des gaz rares.

7. Procédé selon l'une des revendications précédentes, **caractérisé en ce que** lors du traitement au plasma on produit des décharges au moyen d'une décharge inductive à radiofréquences ou d'une décharge à micro-ondes.

8. Procédé selon l'une des revendications précédentes, **caractérisé en ce que** la pression dans l'atmosphère de traitement au plasma est réglée entre 1 et 100 mbar.

9. Appareil (1) pour le traitement de matériaux, en particulier de matériaux sans fin, comme des fils, des barres, des tubes, etc., comprenant une chambre de chauffage (3) pour chauffer un matériau amené (8) pendant son déplacement à travers la chambre de chauffage (3), et un réacteur à plasma (5) agencé en aval de la chambre de chauffage avec au moins une chambre de décharge (10), à travers laquelle le matériau (8) peut être transporté en continu et dans laquelle le matériau peut être soumis à un traitement au plasma pendant son déplacement traversant, **caractérisé en ce que** le réacteur à plasma (5) comprend un système (6) pour établir une atmosphère de traitement au plasma formée d'hydrogène ou d'hydrogène mélangé avec des gaz rares dans ladite au moins une chambre de décharge, et **en ce qu'**une concentration de radicaux hydrogène dans l'atmosphère de traitement au plasma est susceptible d'être établie à au moins 10²⁰ m⁻³.

10. Appareil selon la revendication 9, **caractérisé en ce qu'**il est possible de régler un flux de radicaux hydrogène vers la surface du matériau à traiter (8) dans la chambre de décharge à au moins 10²³ m⁻² s⁻¹.

11. Appareil selon la revendication 9 ou 10, **caractérisé en ce que** les radicaux sont des atomes d'hydrogène neutres ou positivement chargés.

12. Appareil selon l'une des revendications 9 à 11, **caractérisé en ce que** la chambre de chauffage (3) comprend un système de chauffage (9), comme un chauffage résistif, un brûleur à flamme, un chauffage inductif, un système à décharge haute fréquence à couplage capacitif, à laser, un système de chauffage à lumière ou un système de génération de plasma.

13. Appareil selon l'une des revendications 9 à 12, **caractérisé en ce que** la chambre de chauffage (3) comprend des moyens pour l'admission d'hydrogène et en option de gaz rares.

14. Appareil selon l'une des revendications 9 à 13, **caractérisé en ce que** le réacteur à plasma (5) comprend un système de génération de décharge à radiofréquences inductif (22) ou un système de génération de décharge à micro-ondes.

15. Appareil selon l'une des revendications 9 à 14, **caractérisé en ce que** la pression de l'atmosphère de traitement au plasma dans la chambre de décharge (10) est réglable entre 1 et 100 mbar.

16. Appareil selon l'une des revendications 9 à 15, **caractérisé en ce que** ladite au moins une chambre à décharge gazeuse (10) est délimitée par des parois (18) qui sont constituées par un matériau ou qui sont revêtues au niveau des surfaces tournées vers la chambre de décharge avec un matériau qui possède un coefficient de recombinaison plus faible pour la composition des atomes de gaz en molécules ou en radicaux, et le matériau est de préférence un verre, comme par exemple du verre de quartz, ou un polymère fluoré, comme par exemple PTFE.

17. Appareil selon la revendication 16, **caractérisé en ce que** les parois (18, 19) qui délimitent la chambre de décharge (10) sont refroidies, ledit refroidissement ayant de préférence lieu à une température de paroi au-dessous de 60°C.

18. Appareil selon l'une des revendications 9 à 17, **caractérisé en ce qu'**il est prévu un étage de séparation entre la chambre de chauffage (3) et la chambre de décharge (10) du réacteur à plasma (5), étage de séparation dans lequel les atmosphères gazeuses dans la chambre de chauffage et dans la chambre de décharge sont découplées l'une par rapport à l'autre.

19. Appareil selon l'une des revendications 9 à 18, **caractérisé en ce que** la pression (P1) dans la chambre de chauffage (3) est réglée plus basse que la pression (P3) dans la chambre de décharge (10).
